# EUROPÄISCHE PATENTANMELDUNG

(11) **EP 1 755 195 A1**
(43) Veröffentlichungstag der Anmeldung: **21.02.2007**
(21) Anmeldenummer: 05017989.4
(22) Anmeldetag: 18.08.2005
(51) Int. Cl.: H01R 12/32

(54) **Hochstromkontaktelemente mit elastischen Einpresszonen**

(71) Anmelder: Broch, Franz, 25123 Brescia (IT)
(72) Erfinder: Broch, Franz, 25123 Brescia (IT)

(57) **Zusammenfassung**

Kontaktelemente mit elastischen Einpresszonen, die so geformt sind, dass die gesamte Laenge der metallisierten Huelse der Durchkontaktierung einer Leiterplatte als Kontaktflaeche verwendet wird und somit die Uebertragung hoher elektrischer Stroeme auf eine Leiterplatte ermoeglicht. Die Kontaktelemente dienen zur Anbindung von Verdrahtungen, Steckerelementen oder mechanischen Bauelementen an Leiterplatten oder andere Bauelemente.

## Beschreibung

Die Erfindung bezieht sich auf die Einspeisung von elektrischen Stroemen auf Leiterplatten und insbesonders auf eine loetfreie Anschlussmoeglichkeit von Stromzuleitungen mittels Steckverbinder oder Schraubanschluss.

Wegen der allgemein bekannten Nachteile einer Loetverbindung ist es von Vorteil, die Loetverbindung durch eine Einpressverbindung zu ersetzen. Diese Einpresstechnik, auch Press-Fit genannt, ist in der Norm "DIN EN 60352-5" als "massive" (starre), bzw. elastische" (flexible) Einpresstechnik beschrieben. Derartige Einpresskontakte sind im Handel in mannigfaltiger Art erhaeltlich.

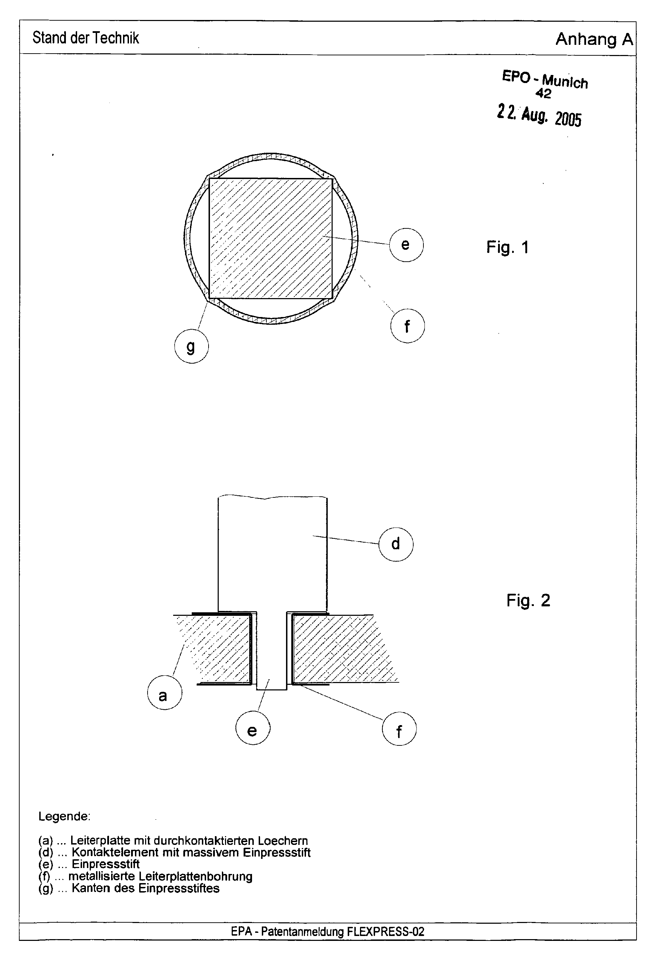

Wie in Fig. 2 (Anhang A) dargestellt werden die Kontaktelemente (d) mit den vierkantigen massiven Einpressstiften (e) in die durchkontaktierten Bohrungen (f) der Leiterplatte (a) eingepresst. Da die Diagonale der vierkantigen Einpressstifte (e) groesser als der Innendurchmesser der metallisierten Leiterplattenbohrung (f) ist (siehe Fig. 1 - Anhang A), verformt sich diese Bohrung durch den Einpressdruck an den vier Kanten (g) und stellt somit in diesem Bereich die elektrische Verbindung zwischen Leiterplatte und Kontaktelement dauerhaft her. Nachteilig bei dieser Art der Einpressung ist, dass wie erwaehnt, die Einpressstifte nur an den Kanten die elektrische Verbindung herstellen und somit, wie dies aus Schliffbildern ersichtlich ist, nur etwa 10% der Metallhuelse der Leiterplattenbohrung zur Stromuebertragung herangezogen werden. Dadurch ist die Uebertragung der Stromstaerke erheblich begrenzt.

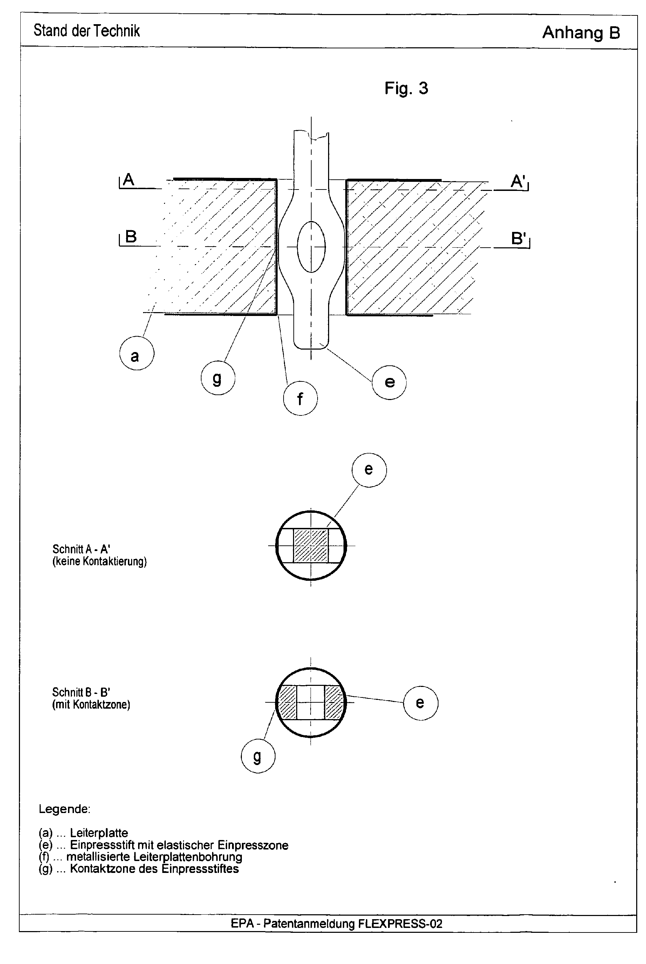

Die nach dem heutigen Stand der Technik verwendeten elastischen Einpresszonen haben den Nachteil, dass die Beruehrungsflaeche zwischen dem Einpressstift und der metallisierten Huelse der Leiterplatte sehr gering ist, weil sie sich nur auf den Mittelteil der Bohrung konzentriert. (siehe Fig. 3, Schnitt A-A', B-B' - Anhang B), was die Groesse der Stromuebertragung automatisch begrenzt. Aus diesem Grund wird die Technik der elastischen Einpressung fast ausschliesslich in der Daten- und Nachrichtentechnik verwendet, wo die zu uebertragenden Stroeme relativ gering sind, jedoch nicht in der Leistungselektronik, wo Stroeme ueber 10A der Normalfall sind. Der Vorteil dieser Technik besteht jedoch darin, dass durch die kleine Beruehrungsflaeche die Einpresskraft relativ gering ist, was bei Steckverbindern mit hohen Polzahlen, wie sie in der erwaehnten Daten- und Nachrichtentechnik ueblich sind, die gesamte Einpresskraft auf ein anwendbares Mass begrenzt.

Ziel der vorliegenden Erfindung ist es, einen Einpressstift mit einer elastischen Einpresszone herzustellen, der all die oben erwaehnten Nachteile behebt, daher fuer die Leistungselektronik einsetzbar und gleichzeitig wirtschaftlich sinnvoll fuer eine Massenproduktion anwendbar ist.

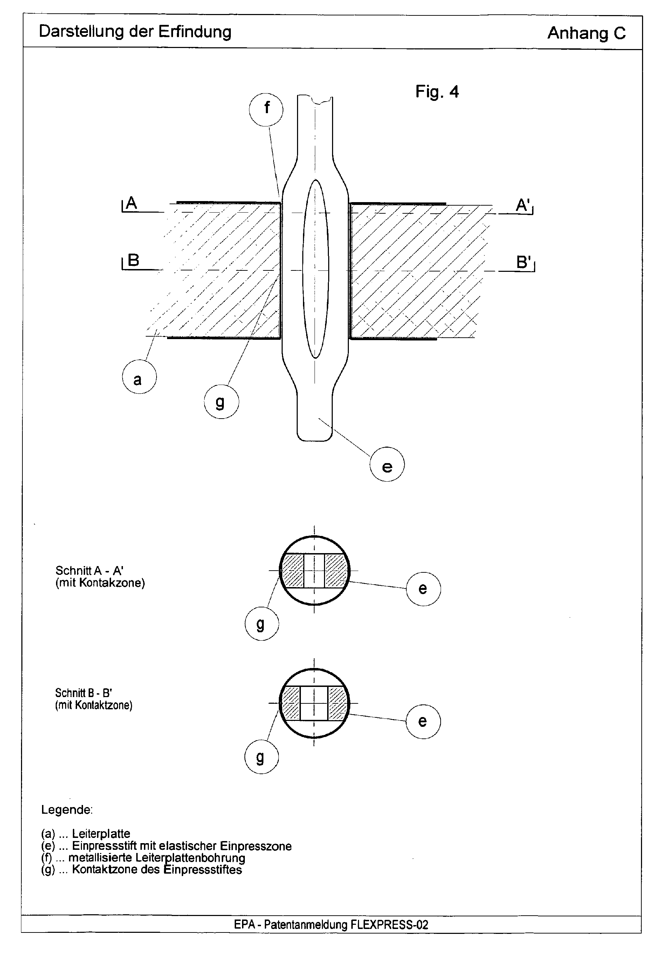

Charakteristisch fuer diese Erfindung ist es, dass die Laenge der elastischen Einpresszone groesser als die Leiterplatte dick ist (siehe Fig. 4 Schnitt A-A', B-B' - Anhang C). Dadurch wird sichergestellt, dass die elastische Einpresszone die gesamte Laenge der metallisierten Bohrung in der Leiterplatte beruehrt und somit als Kontaktflaeche agiert. Der zu uebertragende Strom fliesst daher direkt von der Leiterbahn in den Einpressstift und nicht zuerst ueber die metallisierte Huelse der Leiterplattenbohrung, wie dies beim heutigen Stand der Technik der Fall ist.

Eine weitere Vergroesserung der Kontaktflaeche zwischen Einpressstift und der metallisierten Huelse der Leiterplattenbohrung erzielt man durch die spezielle Formgebung der Einpresszone. Die Einpresszone erhaelt ihre spezielle Form durch einen Stanz- und/oder Praegvorgang. Dadurch wird der Gesamtdurchmesser der Einpresszone so erweitert, dass er groesser ist als der Lochdurchmesser. Im eingepressten Zustand entsteht daher eine Ferderwirkung, die die Kontaktierung ueber die gesamte Laenge des metallisierten Bohrlochs gewaehrleistet. Der Vorteil des Einpressstiftes mit dieser Federwirkung gegenueber dem klassischen starren Einpressstift besteht darin, dass er sich an die metallisierte Huelse der Bohrung anpasst und deshalb in der Lage ist, Fertigungstoleranzen, wie sie besonders bei HAL-Verzinnung der Bohrungen entstehen, auszugleichen. Diese Anpassung an das Bohrloch verhindert eine moegliche Zerstoerung des Bohrlochs.

Dadurch, dass sich die Kontaktzone des Einpressstiftes ueber die geamte Laenge des Bohrlochs, welche der Dicke der Leiterplatte entspricht, an die Wandung anlegt, erhoeht sich die effektive Kontaktflaeche was wiederum einer Verringerung des elektrischen Uebergangswiderstandes zwischen dem Einpressstift und dem Bohrloch gleichkommt.

Der Einpressstift kann beispielsweise, wie aus Fig. 4 (Anhang C) ersichtlich als Blechstreifen mit einem zentral gestanzten Langloch ausgefuehrt werden (O-Form). In diesem Fall wird das Langloch im eingepressten Zustand zusammengedrueckt, woraus die Federwirkung resultiert, die den Anpressdruck an die Metallisierung des Bohrlochs gewaehrleistet.

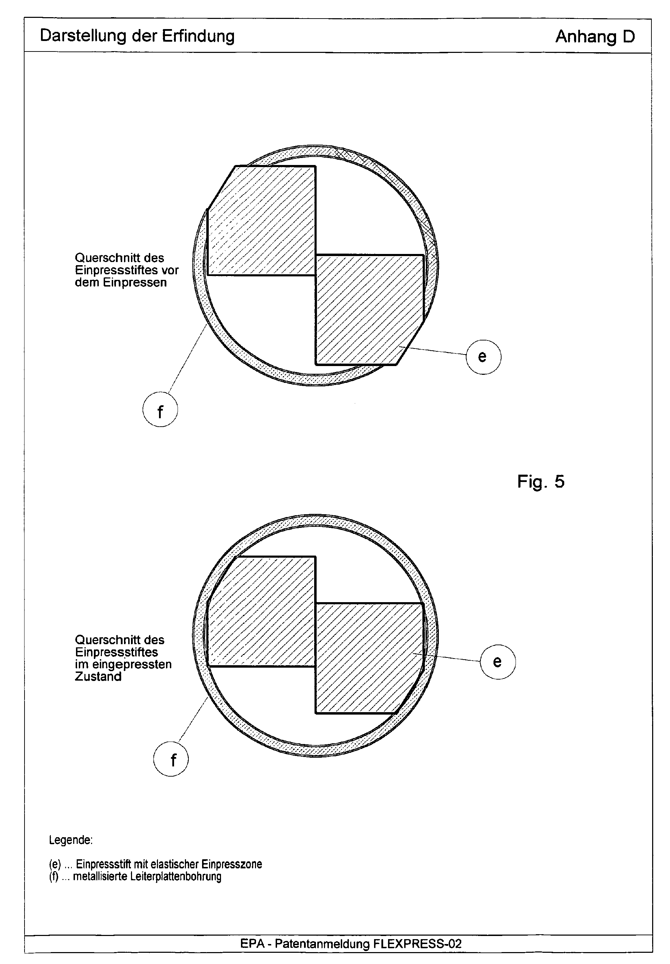

Auch kann der Einpressstift, wie aus Fig. 5 (Anhang D) ersichtlich ist, in eine stilisierte Z-Form gestanzt und angepraegt werden. Hierbei wird ein vorgeformter Blechstreifen in der Mitte ueber die Laenge des Bohrloches geteilt und soweit aufgebogen, dass die Gesamtbreite groesser als der Lochdurchmesser ist. Dadurch entstehen zwei federnde Schenkel, die sich beim Einpressen annaehern und somit die zur Kontaktierung notwendige Federwirkung erzeugen.

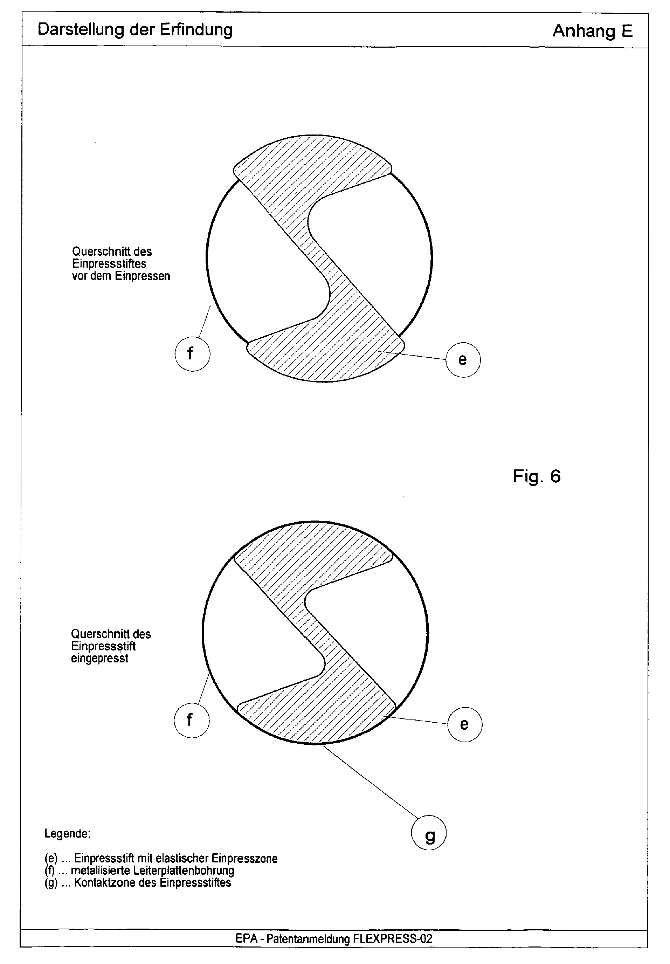

Bei der in Fig. 6 (Anhang E) dargestellten stilisierten S-Form wird der Einpressstift so gepraegt, dass der Querschnitt, dessen Gesamtbreite groesser als der Lochdurchmesser ist, einer S-Form gleicht. Durch das Einpressen wird das "S" gestaucht und legt sich somit vollkommen an die metallisierte Huelse der Bohrung an.

Die Wahl der Formgebung haengt vom verwendeten Material des Einpressstiftes und vom Lochdurchmesser ab.

Die in dieser Erfindung dargestellten elastischen (flexiblen) Einpresszonen besitzen gegenueber einer starren (massiven) Einpresszone (siehe Fig. 1 - Anhang A) und einer bis jetzt ueblichen elastischen Einpresszone, bei der nur in der Mitte des Bohrlochs eine Kontaktierung besteht (siehe Fig. 3 - Anhang B), den Vorteil, dass etwa die Haelfte der gesamt moeglichen Kontaktflaeche zur Stromuebertragung zur Verfuegung steht und nicht nur etwa 5 bis 10%, wie dies nach dem heutigen Stand der Technik der Fall ist.

Die in dieser Erfindung dargestellten Einpresszonen besitzten deshalb wegen ihrer wesentlich groesseren Kontaktflaeche zwischen dem Einpressstift und der Metallisierung des Bohrlochs auch einen viel kleineren Uebergangswiderstand zwischen Kontaktelement und Leiterplatte. Daher ist die maximale Stromuebertragung praktisch nicht mehr von der Einpresszone abhaengig, sondern nur noch von der Zuleitung bzw. von der Beschaffenheit der Leiterbahnen auf der Leiterplatte.

Die Kontaktelemente koennen so bearbeitet werden, dass sie, wie in Anhang F dargestellt, als Buchse (d) (Fig. 7) oder als Stift (d) (Fig. 8) fuer eine Steckverbindung verwendet werden koennen. Auch koennen sie beispielsweise mit einem Loch oder Gewinde versehen werden, um das Anschrauben eines Kabelschuhs (b) (Fig. 9) zu ermoeglichen.

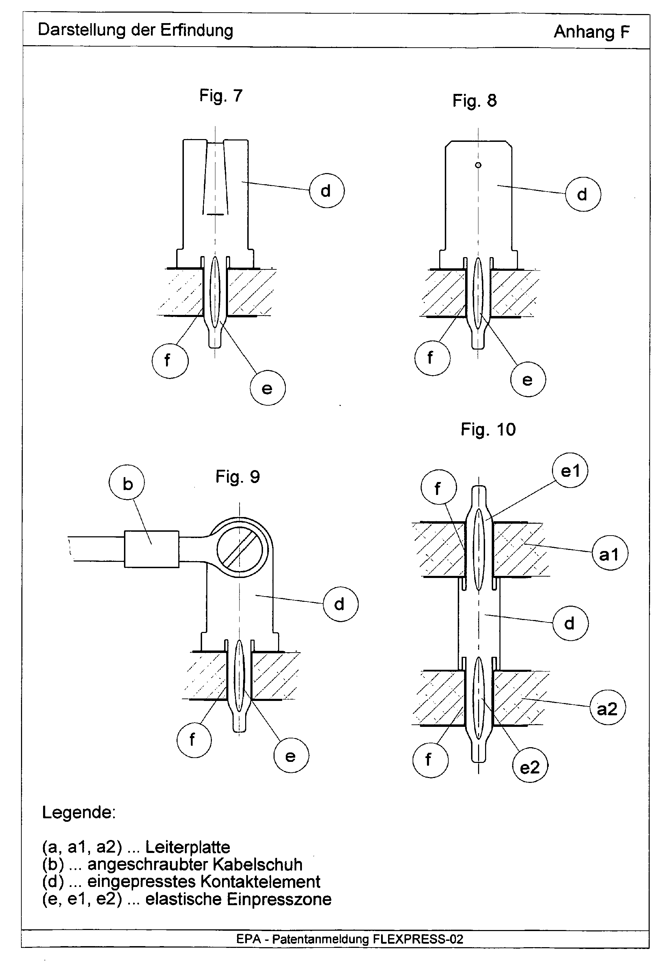

Um den Strom von einer Leiterplatte (a2) auf eine darueberliegende Leiterplatte (a1) im "Huckepack"-Verfahren zu uebertragen, koennen die Kontaktelemente (d) mit zwei Einpresszonen (e1, e2) versehen werden, wie dies in Fig. 10 dargestellt wird.

## Patentansprüche

1. Kontaktelement, das mit einer **elastischen** Einpresszone versehen ist, welche **die gesamte** Laenge der metallisierten Huelse eines Bohrloches einer Leiterplatte als Kontaktflaeche verwendet.

2. Kontaktelement nach Anspruch 1, wobei die Einpresszone die Form eines stilisierten "O" (Fig. 4 - Anhang C) aufweist, wobei das Langloch laenger als die Leiterplatte dick ist.

3. Kontaktelement nach Anspruch 1, wobei der Querschnitt der Einpresszone die Form eines stilisierten "Z" (Fig. 5 - Anhang D) aufweist, das sich durch diese spezielle Formgebung dem metallisierten Loch anpasst.

4. Kontaktelement nach Anspruch 1, wobei der Querschnitt der Einpresszone die Form eines stilisierten "S" (Fig. 6 - Anhang E) aufweist, das sich durch diese spezielle Formgebung dem metallisierten Loch anpasst.

5. Kontaktelement nach Anspruch 1, 2, 3 und 4, wobei eine am Kontaktelement angebrachte Buchse (Fig. 7 - Anhang F) oder ein Stift (Fig. 8 - Anhang F) die Funktion einer Steckverbindung uebernimmt.

6. Kontaktelement nach Anspruch 1, 2, 3 und 4, wobei eine am Kontaktelement entsprechend angebrachte Bohrung bzw. ein Gewinde dazu dient, dass Kabelverbindungen (Fig. 9 - Anhang F), Stromschienen oder andere Bauteile befestigt werden koennen.

7. Kontaktelement nach Anspruch 1, 2, 3 und 4, wobei am Kontaktelement zwei Einpresszonen angebracht werden (Fig. 10 _ Anhang F), die die Verbindung von einer Leiterplatte zur anderen uebernehmen.
